# EUROPEAN PATENT APPLICATION

(11) **EP 4 601 002 A1**
(43) Date of publication of application: **13.08.2025**
(21) Application number: 25156447.2
(22) Date of filing: 07.02.2025
(51) Int. Cl.: H01L 23/427

(54) **A HEAT DISSIPATION SUBSTRATE FOR A POWER SEMICONDUCTOR MODULE, A POWER SEMICONDUCTOR MODULE INCLUDING THE SAME AND A POWER CONVERTER INCLUDING THE SAME, AND MANUFACTURING METHOD OF THE HEAT DISSIPATION SUBSTRATE FOR A POWER SEMICONDUCTOR MODULE**

(30) Priority: 08.02.2024 KR 20240019559; 31.05.2024 KR 20240072000; 26.12.2024 KR 20240197483
(71) Applicant: LX Semicon Co., Ltd., Daejeon 34027 (KR); FJ Composite Materials Co., Ltd., Chitose, Hokkaido 066-0009 (JP)
(72) Inventor: CHO, Nam Tae, 34027 Daejeon (KR); LEE, Yun Tae, 34027 Daejeon (KR); TSUSHIMA, Eiki, Hokkaido, 066-0027 (JP)
(74) Representative: Ter Meer Steinmeister & Partner

(57) **Abstract**

The embodiment relates to a heat dissipation substrate for a power semiconductor module, a power semiconductor module including the same, a power converter including the same, and a method of manufacturing the same. A heat dissipation substrate for a power semiconductor module according to an embodiment includes an insulating substrate, a lower metal plate disposed below the insulating substrate, and an upper metal plate disposed on the insulating substrate, wherein the lower metal plate has a hollow structure.

## Description

### TECHNICAL FIELD

The embodiment relates to a heat dissipation substrate for a power semiconductor module, a power semiconductor module and power converter including the same, and a method of manufacturing a heat dissipation substrate for a power semiconductor module.

Additionally, the embodiment relates to a technology for heat dissipation components for semiconductor devices, etc.

### BACKGROUND

Power conversion modules are used not only in eco-friendly vehicles such as electric vehicles and fuel cell vehicles, but also in various electrical and electronic devices such as electric vehicle chargers, energy storage devices, power supply devices, or railways. It performs functions such as power conversion (DC↔AC), motor drive switching, and power control, etc.

The power conversion module includes various components such as a power semiconductor device, a heat dissipation substrate, a base plate, a molding silicon, a case, a terminal, etc. However, the heat generated from the power semiconductor device causes thermo-mechanical stress in each component of the power semiconductor module, and the life of the power semiconductor device may be reduced due to thermal fatigue of the joint. Accordingly, it is important to design the reliability of the power semiconductor module that dissipates the heat generated from the power semiconductor device through the heat dissipation substrate to maintain the temperature of the junction of the power semiconductor device below an appropriate temperature.

Conventional heat dissipation substrates for power semiconductors can be classified into DBC (Direct Bonded Copper) and AMB (Active Metal Brazing) methods depending on the bonding method. The DBC method is a method of forming an oxide film on the copper (Cu) layer and then bonding it directly to the ceramic, while the AMB method involves brazing by interposing a paste containing metal particles with a low melting point between the base metal and ceramic as an intermediate material.

Recently, SiC power conversion modules of high-voltage/high-power such as 1200V, 200Aare used to improve the performance of hybrid or electric vehicles, or autonomous vehicles. And the operating temperature of power semiconductor devices during operation of these high-performance electric vehicles is close to 300°C on average. Also, the instantaneous maximum operating temperature is close to extremely high temperature of 350°C to 700°C.

In such an ultra-high temperature, high voltage, and high current operating environment, the existing bonding materials themselves may re-melt, and the pores present in the bonding area may cause a heat trap phenomenon or drastically shorten the life of the power semiconductor module. Also, these may cause thermal runaway, which can lead to the destruction of power semiconductor devices and have a serious impact on driver safety.

In the prior art, various heat dissipation components and heat dissipation modules such as heat sinks, heat dissipation plates, heat pipes, and vapor chambers are used to solve the heat generation problem of electronic devices such as power semiconductor modules.

For example, prior art 1 (US2020132392A1: 2020.04.30) is an invention related to 'Vapor Chamber Heat Spreader for Power Electronic Assembly' (see the patent document information in the prior art documents below).

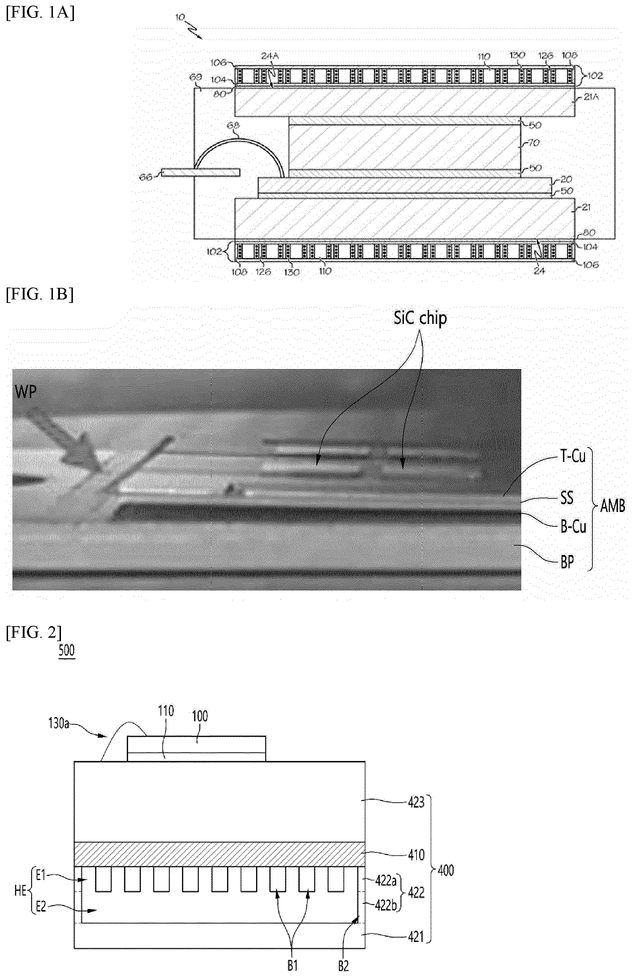

FIG. 1A is a diagram of FIG. 2 relating to the power electronic assembly 10 of prior art 1.

In prior art 1, each component of the power electronic assembly 10 is joined by a bonding layer 50. Specifically, the lower and upper sides of the electronic device 20 of Prior art 1 are adhered to the substrate 21 and the spacer layer 70, respectively, by an adhesive layer 50. Additionally, the upper side of the spacer layer 70 is adhered to the auxiliary substrate 21A by an adhesive layer 50. In prior art 1, the substrate 21 and the auxiliary substrate 21A are DBC (Direct Bonded Copper) heat dissipation substrates in which a copper layer is directly bonded to the surface of a ceramic insulating substrate. Prior art 1 includes a wire wiring 68 that electrically connects the gate electrode 66 and the electronic device 20.

Meanwhile, prior art 1 includes a substrate 21 bonded with an adhesive layer 50, an electronic device 20, a spacer layer 70, an auxiliary substrate 21A, a wiring 68, and a gate electrode 66 which are packaged by resin 69. After packaging, a separately manufactured vapor chamber heat spreader 102 is applied to the cooling surface 24A of the substrate 21 and the cooling surface 24A of the auxiliary substrate 21A with thermal grease and the vapor chamber heat spreader 102 is bonded together by an adhesive layer 80 containing thermal grease or a non-conductive material and perform a heat dissipation function. The vapor chamber heat spreader 102 includes an evaporator plate 104, a condenser plate 106, a side wall 108, a vapor chamber 110, a heat compensation layer 130, and a fin 126. And the heat compensation layer 130 increases heat capacity by including core-shell phase change particles.

The vapor chamber heat spreader 102 of prior art 1 includes a working fluid disposed in the vapor chamber 110, and the working fluid is a fluid having a vaporization temperature within the operating temperature range of the vapor chamber. The working fluid evaporates at the evaporation surface of the evaporator plate 104 and condenses at the condensation surface of the condenser plate 106. The condensed working fluid is transported by capillary action along the condenser plate 106 and the side wall 108 and/or fins 126 to the evaporator plate 104, and is evaporated again at the hot spot of the evaporator plate 104 to vaporize.

However, when the separately manufactured vapor chamber heat spreader 102 as in prior art 1 is adhered to the substrate 21 or the auxiliary substrate 21Aby the adhesive 80, there is a problem in that the heat transfer path of vapor emitted from the electronic device 20 to the chamber heat spreader 102 become longer. Also, there is a problem in that a separate adhesive layer is interposed between the vapor chamber heat spreader 102 and the substrate 21 or the auxiliary substrate 21A, thereby generating thermal resistance and decreasing heat transfer efficiency such that the vaporization of the working fluid does not occur properly, leading to a decrease in heat dissipation performance.

Also, as in prior art 1, when the separately manufactured vapor chamber heat spreader 102 is bonded to the substrate 21 or the auxiliary substrate 21A by the adhesive 80, there is a problem in that separation of the joint interface occurs or warpage of components occurs due to a difference in thermal expansion coefficient with the bonded substrate 21 or the auxiliary substrate 21A.

For example, FIG. 1B is a photograph showing warpage (WP) occurring after the AMB heat dissipation substrate which was bonded to the base plate (BP) according to the comparative technology.

In the heat dissipation substrate manufactured with comparative AMB technology, there is a significant difference in coefficient of thermal expansion (CTE) between insulating substrate SS, upper copper plate (T-Cu), lower copper plate (B-Cu), SiC chip, and base plate (BP). For example, the thermal expansion coefficient of the AlN insulation substrate SS is 4.5×10⁻⁶/°C, the thermal expansion coefficient of the top and bottom copper (T-Cu, B-Cu) is 16.0×10⁻⁶/°C, and the thermal expansion coefficient of the SiC chip is 4.0×10⁻⁶/°C. However, in an ultra-high operating temperature environment of 300°C or higher, if warpage (WP) or separation between interfaces occurs as shown in FIG. 1B due to differences in thermal expansion coefficients of each component that makes up the power semiconductor module, the power semiconductor module may be damaged and malfunction may occur.

Accordingly, as in the prior art 1 described above, when the separately manufactured vapor chamber heat spreader 102 is bonded to the heat dissipation substrate 21 or the auxiliary heat dissipation substrate 21A by the adhesive 80, separation of the bonding interface or warpage of the components occurs due to differences in the thermal expansion coefficients of the components' materials. So, since the heat dissipation function of the vapor chamber heat spreader 102 is damaged, the power semiconductor module may rapidly be deteriorated. And this can lead to thermal runaway and the destruction of power semiconductor devices, which can have a serious impact on driver safety.

### [Prior art literature] [Patent Document] S2020132392A1 (2020.04.30)

### SUMMARY

Because the vapor chamber heat spreader is bonded to the heat dissipation substrate by an adhesive, there is a problem that the heat transfer path from the electronic device that generates heat to the vapor chamber heat spreader becomes longer. Additionally, because a separate adhesive layer is interposed between the vapor chamber heat spreader and the heat dissipation substrate, there is a problem that heat transfer efficiency is reduced due to thermal resistance. Accordingly, one of the technical objects of the embodiment is to solve the problem of deterioration of the heat dissipation performance of the working fluid vapor chamber heat spreader.

Additionally, since the heat dissipation substrate and the heat dissipation component are bonded by an adhesive layer, separation of the bonded interface or warpage of the component occurs due to a difference in thermal expansion coefficient of the bonded components. Accordingly, one of the technical objects of the embodiment is to solve the problem of malfunction of power semiconductor modules due to differences in thermal expansion coefficients.

The technical objects of the embodiments are not limited to those described in this item and include those that can be understood through the description of the invention.

A heat dissipation substrate for a power semiconductor module according to the embodiments includes an insulating substrate (410), a lower metal plate (421, 422) disposed below the insulating substrate (410) and an upper metal plate (423) disposed on the insulating substrate (410). The lower metal plate (421, 422) may include a hollow structure HE.

The lower metal plate (421, 422) may include a second metal plate (422) bonded to a bottom of the insulating substrate (410) and a first metal plate (421) bonded to the bottom of the second metal plate (422).

The second metal plate (422) may include a second-first metal plate (422a) having a plurality of first through trenches (E1) arranged in a first direction and bonded to the insulating substrate (410). Additionally, the second metal plate (422) may include a second-second metal plate (422b) having a plurality of second through trenches (E2) arranged in a second direction perpendicular to the first direction and bonded to a bottom of the second-first metal plate (421a).

The first through trench (E1) and the second through trench (E2) may be three-dimensionally connected to form the hollow structure HE.

The second-first metal plate (421a) may include a first body (B 1) between a plurality of spaced apart first through trenches (E1), and the second-second metal plate (421b) may include a second body (B2) between a plurality of spaced apart second through trenches (E2).

A thickness of the third metal plate (423) may be thicker than that of the first metal plate (421) or the second metal plate (422).

The third metal plate (423) may include a circuit pattern on its surface.

The first metal plate (421), the second metal plate (422), and the third metal plate (423) may have the same metal material.

The second metal plate (422) can be directly bonded to the bottom of the insulating substrate without an adhesive layer. The first metal plate (421) can be directly bonded to the bottom of the second metal plate without an adhesive layer.

A power semiconductor module (500) according to the embodiments may include any one of above heat dissipation substrate (400) and a power semiconductor device (100) disposed on the upper metal plate (423).

A method of manufacturing a heat dissipation substrate for a power semiconductor module according to the embodiments includes preparing an insulating substrate (410), preparing a first metal plate (421), a second metal plate (422), and a third metal plate (423), sequentially stacking the first metal plate (421) and the second metal plate (422), stacking the insulating substrate (410) on the second metal plate (422), preparing a stacked substrate set by stacking the third metal plate (423) on the insulating substrate (410), and performing a hot press process on the stacked set of substrates.

The second metal plate (422) may include a second-first metal plate (422a) having a plurality of first through trenches (E1) arranged in a first direction. Also, the second metal plate (422) may include a second-first metal plate (422a) having a plurality of first through trenches (E1) arranged in a first direction and bonded to the insulating substrate (410).

Through the press process, the first through trench (E1) and the second through trench (E2) may be three-dimensionally connected to form the hollow structure HE.

The second-first metal plate (421a) may include a first body (B 1) between a plurality of spaced apart first through trenches (E1), and the second-second metal plate (421b) may include a second body (B2) between a plurality of spaced apart second through trenches (E2).

The second metal plate (422) can be directly bonded to the bottom of the insulating substrate without an adhesive layer, and the first metal plate (421) can be directly bonded to the bottom of the second metal plate without an adhesive layer.

### Effects of the Invention

One of the technical effects of the embodiment can solve the problem of deterioration of the heat dissipation performance of the working fluid vapor chamber heat spreader because the vapor chamber heat spreader is bonded to the heat dissipation substrate by an adhesive.

For example, according to the embodiment, since the hot press process is performed in a vacuum environment of high temperature and high pressure, it is possible to implement a heat dissipation substrate integrally equipped with a metal plate having a hallow structure HE capable of filling a working fluid in the heat dissipation substrate itself. Accordingly, according to the embodiment, the heat transfer path between the power semiconductor device that generates heat and the metal plate having a hollow structure HE is significantly shortened, so that heat transfer efficiency can be improved. As a result, there is a technical effect of significantly improving heat dissipation performance because vaporization of the working fluid can be efficiently performed.

In addition, according to the embodiment, by implementing a heat dissipation substrate integrally equipped with a metal plate having a hollow structure HE capable of enclosing the working fluid in the heat dissipation substrate itself, thermal resistance can be reduced without passing through a separate adhesive layer. So, there is a technical effect that heat transfer efficiency can be improved and heat dissipation performance can be significantly improved.

In addition, one of the technical effects of the embodiment is to solve the problem of malfunction of power semiconductor modules due to differences in thermal expansion coefficients as a heat dissipation substrate and a heat dissipation component are bonded by an adhesive layer such that separation of the bonding interface or warpage of the component occurs.

Specifically, according to the embodiment, since the hot press process is performed in a high temperature and high-pressure vacuum environment, there is a technical effect in that it can be formed integrally with the heat dissipation substrate 400 including a metal plate having a hollow structure HE capable of enclosing a working fluid in the heat dissipation substrate itself.

For example, referring to FIG. 2, the heat dissipation substrate 400 according to the embodiment includes a second metal plate 422 having a hollow structure HE and a first metal integrally bonded to the lower side of the second metal plate 422 such that the interface between the first metal plate 421 and the second metal plate 422 is substantially undistinguished. In addition, the material of the second metal plate 422 having the hollow structure HE and the material of the first metal plate 421 formed integrally below the second metal plate 422 are the same. Accordingly, the difference in thermal expansion coefficient between the first metal plate 421 and the second metal plate 422 is resolved, so there is a special technical effect in that the reliability of the power semiconductor module can be significantly improved due to fundamentally preventing separation of the joint interface or warpage of components.

In addition, according to the embodiments, the hot-pressing process proceeds while the edges of the spacer, first and second metal plates, insulating substrate, and third metal plate that are sequentially stacked in the manufacturing process of the heat dissipation substrate 400 are maintained in alignment. So, there is a special technical effect that enables the implementation of a high-quality heat dissipation substrate integrally equipped with a hollow structure HE.

The technical effects of the embodiments are not limited to those described in this item and include those that can be understood through the description of the invention.

### BRIEF DESCRIPTION OF THE DRAWINGS

FIG. 1A is a diagram of FIG. 2 relating to the power electronic assembly 10 of prior art 1.
FIG. 1B is a photo of warpage (WP) occurring after the AMB heat dissipation substrate according to the comparative technology was bonded to the base plate (BP).
FIG. 2 is a cross-sectional view of a power semiconductor module 500 including a heat dissipation substrate for a power semiconductor according to an embodiment.
FIG. 3 is a cross-sectional view of a power semiconductor device 100 disposed on a power semiconductor module according to an embodiment.
FIG. 4 is a process flow chart of a heat dissipation substrate manufacturing process for power semiconductors according to an embodiment.
FIGS 5 to 10 are cross-sectional views of a heat dissipation substrate manufacturing process for power semiconductors according to an embodiment.
FIG. 11A is a first cross-sectional view of a power semiconductor module 500 including a heat dissipation substrate for a power semiconductor according to an embodiment.
FIG. 11B is a cross-sectional view of a power semiconductor module 502 including a heat dissipation substrate for a power semiconductor according to the second embodiment.
FIG. 12 is a second cross-sectional view of the power semiconductor module 500 including a heat dissipation substrate for power semiconductor according to an embodiment.
FIG. 13 is a diagram in which a heat dissipation component 550 according to an embodiment is disposed on a semiconductor device chip of a circuit board 610.
FIG. 14 is a circuit diagram of a power converter 1000 to which a power semiconductor module according to an embodiment is applied.

### DETAILED DESCRIPTION

Hereinafter, the invention according to the embodiment for solving the above problem will be described in more detail with reference to the drawings.

The power semiconductor module of the embodiment can be used in inverters or converters such as automobiles, computers, home appliances, solar power, and smart grids. Additionally, the power semiconductor module according to the embodiment can be applied to various electrical and electronic devices, such as chargers for electric vehicles, power supplies, or railways, in addition to eco-friendly vehicles.

### <Power semiconductor module including heat dissipation substrate>

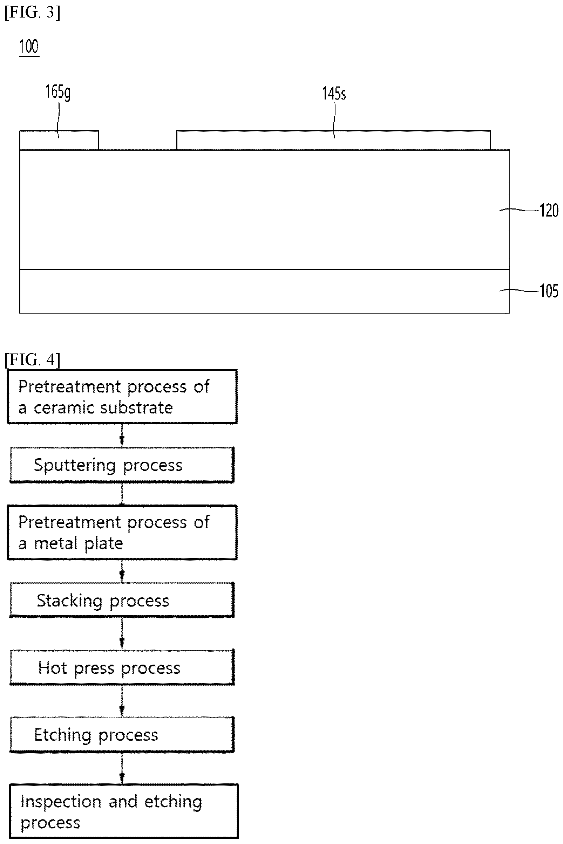

FIG. 2 is a cross-sectional view of a power semiconductor module 500 including a heat dissipation substrate for a power semiconductor according to an embodiment, and FIG. 3 is a cross-sectional view of a power semiconductor device 100 disposed on the power semiconductor module according to an embodiment.

Referring to FIG. 2, the power semiconductor module 500 according to the embodiment may include a heat dissipation substrate 400, a power semiconductor device 100, and a wiring 130a.

For example, the power semiconductor module 500 according to the embodiment may include a heat dissipation substrate 400, a power semiconductor device 100 disposed on the heat dissipation substrate 400, the power semiconductor device 100 and an electrically connected wiring 130a. The power semiconductor device 100 may be bonded using a predetermined adhesive member 110, but is not limited thereto.

FIG. 2 shows an example in which the second metal plate 422 is provided with a hollow structure HE capable of filling a working fluid, but the present invention is not limited thereto. For example, a hollow structure HE capable of encapsulating a working fluid may also be formed in the third metal plate 423.

In the embodiment, the power semiconductor device 100 may be disposed on the heat dissipation substrate 400 through soldering, sintering bonding, phase change bonding such as Transient Liquid Phase Bonding (TLP) bonding, ultrasonic bonding, etc.

Referring briefly to FIG. 3, the power semiconductor device 100 according to the embodiment may include a drain electrode 105, a semiconductor epitaxial layer 120, a source electrode 145s, and a gate electrode 165g. Additionally, the epitaxial layer 120 may include silicon carbide (SiC), but is not limited thereto. In the form of a MOSFET, the source electrode 145s or the gate electrode 165g may include an Al-based metal, and the drain electrode 105 may include a Ti/Ni/Ag metal including a Ti layer, a Ni layer, or an Ag layer, or NiV/Ag, V(vanadium)/Ni/Ag, etc., but is not limited thereto.

Referring again to FIG. 2, the heat dissipation substrate 400 of the embodiment may include a single or multiple metal plates and an insulating substrate 410. For example, the heat dissipation substrate 400 may include a first metal plate 421, a second metal plate 422, an insulating substrate 410, and a third metal plate 423, but is not limited thereto.

The insulating substrate 410 may electrically insulate the second metal plate 422 and the third metal plate 423. The insulating substrate 410 may include a polycrystalline insulating substrate made of ceramic material with high thermal conductivity. For example, the insulating substrate 410 may be one of AlN or Si₃N₄, or Al₂O₃, but is not limited thereto. Hereinafter, the insulating substrate 410 will be described as an example of a polycrystalline substrate made of ceramic, but is not limited thereto, and may also include a single crystal substrate such as a sapphire substrate.

The first metal plate 421, the second metal plate 422, and the third metal plate 423 may include Cu-based metal, but are not limited thereto. For example, the first, second, and third metal plates 421, 422, and 423 may include one or more of Al, Ni, Ag, Mg, or Zn.

One side of the second metal plate 422 may be in contact with the insulating substrate 410 and heat can be dissipated to the other side. A heat dissipation means such as a heat sink may be disposed close to the lower side of the first metal plate 421.

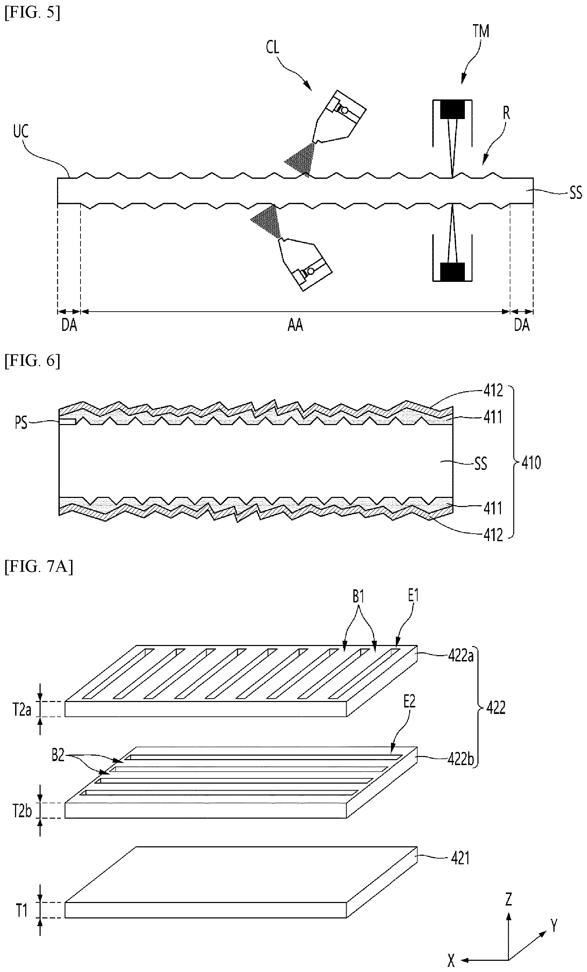

In the embodiment, the second metal plate 422 may include a single or multiple metal plates. For example, the second metal plate 422 may include a second-first metal plate 422a having a first through trench E1 and a first body B1. Additionally, the second metal plate 422 may further include a second-second metal plate 422b having a second body B2 and a second through trench E2 (see FIG. 7A).

Referring again to FIG. 2, the second metal plate 422 is shown to include a second-first metal plate 422a and a second-second metal plate 422b, but is not limited thereto and the second metal plate 422 may also be provided with a single second-first metal plate (422a).

In the second metal plate 422, the first through trench E1 and the second through trench E2 may be three-dimensionally connected to form a hollow structure HE. ) may be filled with a working fluid (not shown) such as acetone, methanol, ethanol, or ultrasonic water.

In addition, the first body B 1 and the second body B2 of the second metal plate 422 may include a porous structure that can contain or absorb the working fluid. For example, the first body B1 and the second body B2 of the second metal plate 422 may be formed through a sintering process and may include a porous structure. Alternatively, the first body B 1 and the second body B2 of the second metal plate 422 may have grooves in the form of fine grooves on their side walls. Alternatively, the first body B1 and the second body B2 of the second metal plate 422 may include a mesh-shaped porous structure.

According to the embodiment, as the heat generated from the power semiconductor device 100 is efficiently transferred to the second metal plate 422 of the heat dissipation substrate, the working fluid can be vaporized and latent heat of evaporation can be absorbed. Thereafter, the working fluid can move toward the lower first metal plate 421 and condense into a liquid by releasing latent heat of evaporation. Additionally, the condensed working fluid may be absorbed into the porous structure of the second metal plate 422 and moved toward the insulating substrate 410. Meanwhile, in the embodiment, the power semiconductor device 100, which is a heat source, may be placed below the heat dissipation substrate 400 and the condensed working fluid may be moved using gravity.

Next, the third metal plate 423 may include a plurality of circuit patterns (not shown) formed through a patterning process such as etching, and the circuit patterns may be electrically connected to the power semiconductor device 100. For example, as shown in FIG. 2, one side of the circuit pattern of the third metal plate 423 may be electrically connected to the power semiconductor device 100 through a wire-like wiring 130a. Additionally, the other side of the circuit pattern of the third metal plate 423 may be connected to an external connection terminal. External connection terminals may include input power, motors, or inverter controllers. When the third metal plate 423 does not undergo a patterning process, the heat dissipation substrate 400 of the embodiment can be used as a heat dissipation component.

According to the power semiconductor module 500 including the heat dissipation substrate 400 for power semiconductors according to the embodiment, since a hot press process is performed in a high temperature and high-pressure vacuum environment, it is possible to implement a heat dissipation substrate integrally equipped with a second metal plate 422 having a hollow structure HE capable of encapsulating a working fluid.

Accordingly, according to the embodiment, the heat transfer path between the power semiconductor device 100 which causes heat generation and the second metal plate 422 having a hollow structure HE can be shortened, thereby improving heat transfer efficiency. There is a technical effect that heat dissipation performance can be significantly improved by efficiently vaporizing the fluid.

According to the embodiment, it is possible to implement a heat dissipation substrate integrally provided with a second metal plate 422 having a hollow structure HE capable of encapsulating a working fluid in the heat dissipation substrate 400 itself without intervening a separate adhesive layer such that heat can be transferred to the second metal plate 422 having a hollow structure HE without passing through an adhesive layer that may cause thermal resistance. Accordingly, the efficiency of heat transfer can be improved, and the vaporization of the working fluid can proceed efficiently, resulting in a technical effect of significantly improving heat dissipation performance.

Additionally, according to the embodiment, the interface between the second metal plate 422 having a hollow structure HE and the first metal plate 421 integrally bonded without an adhesive layer may not be distinguished. Additionally, the material of the second metal plate 422 having the hollow structure HE and the material of the first metal plate 421 formed integrally below the hollow structure HE may be the same such that the difference in thermal expansion coefficient between the first metal plate 421 and the second metal plate 422 can be resolved. Therefore, the embodiment can fundamentally prevent separation of the joint interface or warpage of components such that there are special technical effects that can significantly improve the reliability of power semiconductor modules.

Hereinafter, while explaining the 'manufacturing process of a heat dissipation substrate for a power semiconductor', the technical features of the 'power semiconductor module 500 including a heat dissipation substrate' of this application will be described in detail.

### <Manufacturing process of heat dissipation substrate for power semiconductors>

FIG. 4 is a schematic process flow chart of a heat dissipation substrate manufacturing process for power semiconductors according to an embodiment.

The manufacturing process of the heat dissipation substrate for power semiconductors according to the embodiment may include (1) pretreatment process of the insulating substrate, (2) sputtering process, (3) pretreatment process of metal plates, (4) stacking process of the insulating substrate and the metal plates, (5) a hot press process of the insulating substrate and metal plates. (6) an etching process for the heat dissipation substrate, and (7) an inspection and cutting process for the heat dissipation substrate. The overall manufacturing process of the heat dissipation substrate for power semiconductors according to the embodiment may be controlled by a control unit (not shown) of a central server, and the central server may include a data storage unit (not shown).

The main manufacturing process of the heat dissipation substrate for power semiconductors according to the following embodiment will be described with reference to the drawings.

### (1) Pretreatment process of insulating substrate

Hereinafter, the pretreatment process of the insulating substrate will be described with reference to FIG. 5. In the embodiment, a 'pretreatment process for the insulating substrate' may be performed in a substrate cleaning device (not shown) before the 'stacking process' of the insulating substrate and the metal plate.

The pretreatment process of the insulating substrate may include ① a loading step of the insulating substrate, ② a unique code UC marking process, (3) a cleaning process of the insulating substrate, ④ a thickness measurement process of the insulating substrate, and (5) a loading process into the magazine of the insulating substrate.

### ① Loading step of insulating substrate

First, as shown in FIG. 5, a predetermined insulating substrate base material SS may be prepared and loaded into a substrate cleaning device (not shown). The insulating substrate base material SS may be AlN, Si₃N₄, or Al₂O₃, but is not limited thereto, and may also include a single crystal substrate such as a sapphire substrate. On the surface of the insulating substrate 410, irregularities R with a size of several µm to hundreds of µm may exist, but are not limited thereto.

### ② Unique code UC marking process

According to an embodiment, a unique code UC may be marked on the insulating substrate base material SS loaded in the substrate cleaning device. Afterwards, the unique code UC is read, the reading data can be transmitted and stored wired or wirelessly to the server's data storage, and detailed information on the 'individual heat dissipation substrate' including the 'individual insulating substrate' in the subsequent process can be precisely updated and managed.

The insulating substrate base material SS may include an effective area AA and a dummy area DA. The unique code UC may be marked on the dummy area DA of the insulating substrate base material SS. The unique code UC may include a digital matrix code DMC, a QR code, or a bar code, but is not limited thereto. The unique code UC may be marked by laser marking technology, but is not limited thereto.

In an embodiment, in addition to the unique code UC, a unique ID such as a serial number may also be marked in the dummy area DA of the insulating substrate base material SS.

### (3) Cleaning process of insulating substrate and ④ Thickness measurement process

Referring to FIG. 5, the CDA (Clean Dried Air) cleaning process CL may be performed on the insulating substrate base material SS. In addition, in the embodiment, after cleaning the insulating substrate base material SS, the thickness of 9 points can be measured using a displacement sensor TM, but is not limited thereto.

### ⑤ Loading process of insulating substrate

The insulating substrate base materials may be loaded into predetermined substrate magazines (not shown) and then transferred to a predetermined stacking device. In an embodiment, each substrate magazine may also be marked with a predetermined unique ID or unique code. Accordingly, in the stacking process performed after the sputtering process, the stacking and bonding processes according to the order for manufacturing the heat dissipation substrate can be precisely controlled by reading the unique IDs of the substrate magazines.

### (2) Sputtering process

As described above, the insulating substrates can be transferred to the sputtering device while loaded in substrate magazines, and each insulating substrate can be unloaded and then mounted on the sputtering device to proceed with the sputtering process.

Hereinafter, with reference to FIG. 6, the 'sputtering process for an insulating substrate' of the embodiment will be described.

Referring to FIG. 6, a bonding metal layer 411 of a first thickness may be formed on one surface of the insulating substrate base material SS by sputtering. At this time, in the sputtering process, the unique code UC and unique ID area can be protected by being covered with sprayed parts (PS), etc., so that sputtering can be controlled not to proceed on the unique code UC and unique ID area.

For example, an insulating substrate base material SS is mounted on an anode electrode plate of a predetermined PVD equipment, and a bonding metal layer 411 containing Ti or TiW may be formed at a first thickness of about 2,000 Å to about 4,000 Å in an inert atmosphere such as Ar gas.

Next, the diffusion metal layer 412 may be formed on the bonding metal layer 411 by sputtering. The diffusion metal layer 412 may be formed by sputtering to a thickness greater than the first thickness of the bonding metal layer 411.

The diffusion metal layer 412 may have a melting point lower than the temperature of the hot press process for subsequent bonding. For example, the temperature of the hot press may be in the range of about 900°C to 1100°C, and the diffusion metal layer 412 may be a material with excellent diffusion since diffusion metal layer 412 has a melting point of less than 900°C. For example, the diffusion metal layer 412 may be one or more of Al, Ag, Au, and Sn, but is not limited thereto.

Next, the insulating substrate base material SS on which the diffusion metal layer 412 has been deposited on one surface may be turned over, and then the bonding metal layer 411 and the diffusion metal layer 412 can be sequentially deposited on the opposite surface by sputtering.

According to the embodiment, there is a technical effect of improving the heat dissipation performance of the heat dissipation substrate by reducing thermal resistance by implementing the first and second bonding metal layers 411 and 421 thinly.

In the embodiment, the thickness of the bonding metal layer 411 and the diffusion metal layer 412 for each individual insulating substrate 410 are measured after sputtering, and the thickness data for each unique code UC is transmitted to the server for update management. For example, in the embodiment, the thickness of the bonding metal layer 411 and the diffusion metal layer 412 may be measured by measuring the sheet resistance of the individual insulating substrate 410, but the present invention is not limited thereto. The individual insulating substrates 410, on which the thicknesses of the bonding metal layer 411 and the diffusion metal layer 412 have been measured, can be transferred to the stacking device after loaded back into the substrate magazines.

### (3) Pretreatment process of metal plate

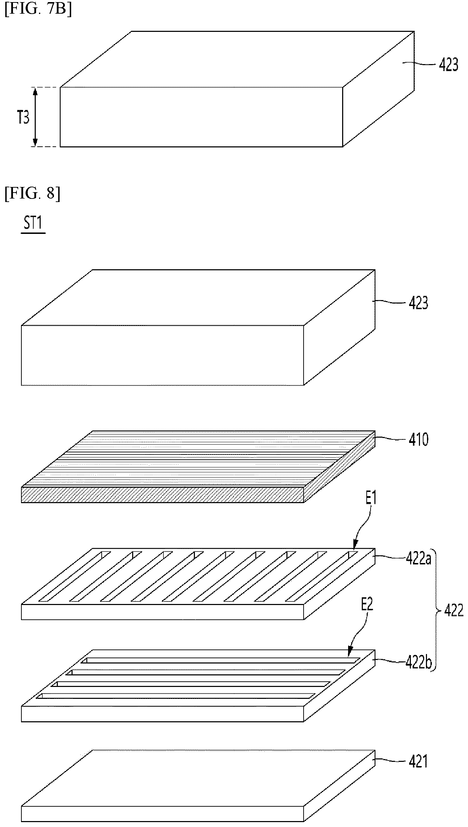

Hereinafter, a pretreatment process of metal plate according to an embodiment will be described with reference to FIGS. 7A and 7B. The metal plate may include a single or multiple metal plates. For example, the metal plate may include a first metal plate 421, a second metal plate 422, and a third metal plate 423, but is not limited thereto.

The metal plate may be a metal plate with excellent electrical conductivity and thermal conductivity. For example, the metal plate may be a Cu plate or a Cu alloy plate, but is not limited thereto. For example, the metal plate may include any one or more of Al, Ni, Ag, Mg, and Zn. The metal plate may also be referred to as a metal substrate. In an embodiment, the first metal plate 421, the second metal plate 422, and the third metal plate 423 may be marked with a predetermined unique ID or unique code.

The pretreatment process of metal plate may include a cleaning process and a thickness measurement process for the metal plate.

Metal plates can be classified into multiple groups depending on their thickness. For example, metal plates may be classified into a first metal plate 421, a second metal plate 422, and a third metal plate 423 according to their thickness, but are not limited thereto. The third metal plate 423 may be thicker than the first and second metal plates 421 and 422, but is not limited thereto.

The first metal plate 421 may have a first thickness T1. For example, the first metal plate 421 may have a first thickness T1 of 100 µm to 300 µm.

In addition, the second metal plate 422 includes a second-first metal plate 422a having a second-first thickness T2a and a second-second metal plate 422b having a second-second thickness T2b.

For example, the second-first metal plate 422a may have a second-first thickness T2a of 100µm to 300µm. The second-second metal plate 422b may have a second-second thickness T2b of 100 µm to 300 µm.

The second-first metal plate 422a may include a plurality of first through trenches E1 arranged in the first direction (X). Additionally, the second-second metal plate 422b may include a plurality of second through trenches E2 arranged in the second direction (Y) perpendicular to the first direction (X). In the subsequent hot pressing process, the first through trench E1 and the second through trench E2 may be three-dimensionally connected to form a hollow structure HE.

The second-first metal plate 422a may include a first body B 1 between a plurality of spaced apart first through trenches E1, and the second-second metal plate 422b may include a second body B2 between the plurality of spaced apart second through trenches E2. The second body B2 of the second-second metal plate 421b and the first body B1 of the second-first metal plate 421a may have a porous structure that can cause capillary action.

For example, the first body B 1 of the second-first metal plate 422a and the second body B2 of the second-second metal plate 422b may include a porous structure which can contain or absorb the working fluid. For example, the first body B 1 and the second body B2 of the second metal plate 422 may be formed through a sintering process and may include a porous structure. Alternatively, the first body B 1 and the second body B2 of the second metal plate 422 may have grooves in the form of fine grooves on their side walls. Alternatively, the first body B1 and the second body B2 of the second metal plate 422 may include a mesh-shaped porous structure. Meanwhile, in the embodiment, the power semiconductor device 100, which is a heat source, may be placed below the heat dissipation substrate 400 and the condensed working fluid may be moved using gravity.

In the field of conventional heat dissipation substrates, there has been no attempt to implement a porous structure in the heat dissipation substrate itself, and even in internal research, buckling of pores occurred when providing a porous structure in the heat dissipation substrate itself through hot pressing such that there were significant technical problems. On the other hand, according to the embodiment, buckling of pores can be prevented by forming a porous structure in the second metal plate 422 through a sintering process. In addition, according to the embodiment, buckling of the pore can be prevented by providing a groove in the form of a groove on the side wall. Additionally, according to the embodiment, there is a technical effect of preventing buckling of pores in a hot press process by implementing pores in a cross shape.

Also, according to an embodiment, the hot press process may be performed after impregnating a predetermined fluid into the porous structure provided in the second metal plate before the hot press process. Accordingly, there is a special technical effect of preventing buckling of pores by maintaining the porous structure by the vapor pressure of the fluid.

Next, referring to FIG. 7B, the third metal plate 423 may have a third thickness T3. For example, the third metal plate 423 may have a third thickness T3 of 600µm to 900µm.

In the embodiment, the first metal plate 421, the second-first metal plate 422a, the second-second metal plate 422b, and the third metal plate 423 have a marked unique ID or a marked unique code. At this time, the metal plates with respective thicknesses or through trenches may be loaded into the first metal magazine, the second-first metal magazine, the second-second metal magazine, and the third metal magazine, respectively, and then transferred to a predetermined stacking device. In an embodiment, each of the first, second-first, second-second, and third metal magazines may be marked with a predetermined unique ID or unique code.

According to an embodiment, metal plates can be sorted and loaded into the first, second-first, second-second or third metal magazines according to thickness, a through trench provided or not, or the through trench direction. The thickness of metal magazines, information on penetration trenches, and classification loading information can be stored and managed on the upper server.

In addition, the unique information of each metal plate can be precisely updated and managed with information of loaded metal magazine.

Accordingly, in the subsequent stacking process, the hot press process can be performed by precisely matching the stacking order by reading the unique IDs of the first, second-first, second-second or third metal magazines.

### (4) Stacking process of insulating substrate and metal plate

Next, the stacking process of the insulating substrate and the metal plate will be described with reference to FIG. 8.

FIG. 8 is a conceptual diagram of stacking an insulating substrate and a metal plate in an embodiment.

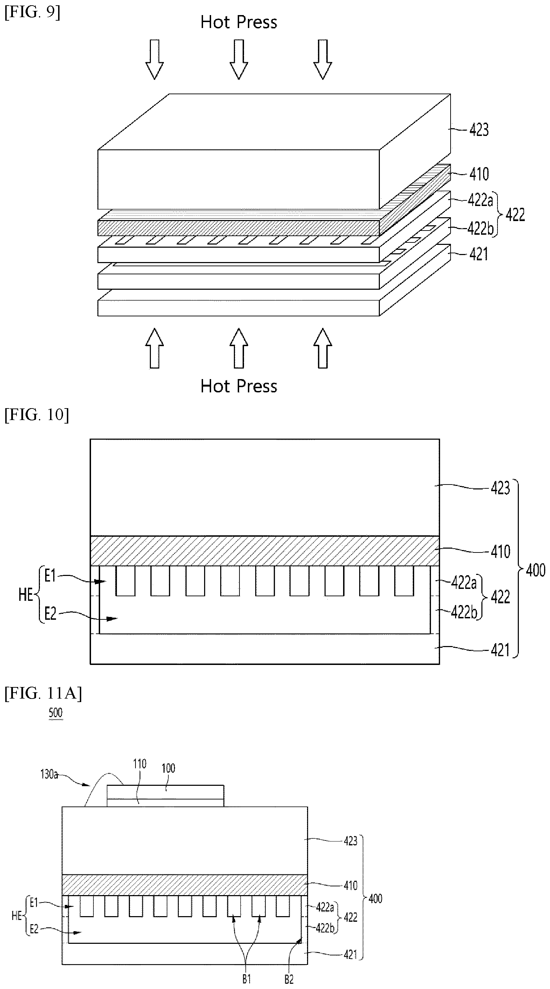

A first stacked set ST1, which will be the heat dissipation substrate 410 (see FIG. 10) of the embodiment, may be prepared (see FIG. 8).

For example, referring to FIG. 8, a first metal plate 421, a second-second metal plate 422b, and a second-first metal plate 422a may be sequentially stacked on a first carbon spacer (not shown). And the insulating substrate 410, the third metal plate 423, and a second carbon spacer (not shown) may be sequentially stacked. In the embodiment, graphite (not shown) may be stacked after 10 stacking sets are performed, but the method is not limited thereto.

According to an example, the stacked unit set can be put into a hot press with its alignment maintained and the hot press process proceeds, thereby realizing a high-quality heat dissipation substrate with a hollow structure HE without distortion of the stacked unit.

Also, according to the embodiment, in addition to the 'stacking set' can be put into the hot press with the alignment maintained, carbon spacers can be placed on the upper and lower parts to offset the pressure deviation, thereby maintaining uniform pressure distribution. So, there is a technical effect that can reduce the risk of cracks that may occur in ceramics.

### (5) Hot pressing process of insulating substrate and metal plate

Next, the hot press bonding process of the embodiment will be described with reference to FIG. 9.

Referring to FIG. 9, a hot press process may be performed in a vacuum state on the stacking set inputted into the hot press device (not shown), thereby forming a heat dissipation substrate 400 for a power semiconductor module according to the embodiment as shown in FIG. 10.

The temperature of the hot press process may be about 900°C to 1,100°C. Preferably, the temperature of the hot press process may be about 950°C to 1,000°C, but is not limited thereto. The vacuum degree of the hot press process may be 1.0×10⁻¹ torr or more, but is not limited thereto. Additionally, the pressure of the hot press process may be from about 10 MPa to about 100 MPa, but is not limited thereto.

In the prior art, various heat dissipation components and heat dissipation modules such as heat sinks, heat dissipation plates, heat pipes, and vapor chambers were employed to solve the heat generation problem of electronic devices such as power semiconductor modules.

However, in the prior art, when the separately manufactured vapor chamber heat spreader is adhered to the substrate or the auxiliary substrate by the adhesive, there is a problem in that the heat transfer path of vapor emitted from the electronic device to the chamber heat spreader become longer. Also, there is a problem in that a separate adhesive layer is interposed between the vapor chamber heat spreader and the substrate or the auxiliary substrate, thereby generating thermal resistance and decreasing heat transfer efficiency such that the vaporization of the working fluid does not occur properly, leading to a decrease in heat dissipation performance.

In addition, the difference in thermal expansion coefficient between the separately bonded components and the heat dissipation substrate material may cause separation of the bonding interface or warpage of the components, which may cause malfunction of the power semiconductor module.

Since the vapor chamber heat spreader is bonded to the heat dissipation substrate by an adhesive, there is a problem that the heat transfer path from the electronic device that generates heat to the vapor chamber heat spreader becomes longer. Additionally, because a separate adhesive layer is interposed between the vapor chamber heat spreader and the heat dissipation substrate, there is a problem that heat transfer efficiency is reduced due to thermal resistance. Accordingly, one of the technical objects of the embodiment is to solve the problem of deterioration of the heat dissipation performance of the working fluid vapor chamber heat spreader.

Additionally, since the heat dissipation substrate and the heat dissipation component are bonded by an adhesive layer, separation of the bonded interface or warpage of the component occurs due to a difference in thermal expansion coefficient of the bonded components. Accordingly, one of the technical objects of the embodiment is to solve the problem of malfunction of power semiconductor modules due to differences in thermal expansion coefficients.

Meanwhile, in the conventional heat dissipation substrate technology field, the heat dissipation problem was solved by separately combining or placing various heat dissipation components such as heat sinks, heat dissipation plates, heat pipes, and vapor chambers on the heat dissipation substrate. But there was no consideration or research on forming heat dissipation components integrally with the metal plate itself constituting the heat dissipation substrate.

Specifically, when direct bonding between Cu metal plates and Cu metal plates occurs, Cu to Cu bonding does not proceed properly due to the oxide layer generated on the Cu surface. Also, since the oxide layer is present at the bonding interface, there is a problem of deteriorating the thermal and electrical characteristics of the heat dissipation substrate by causing high electrical and thermal resistance.

Meanwhile, in the field of conventional heat dissipation substrate technology, there has been no attempt to form a metal plate with a hollow structure integrally with a heat dissipation substrate. Also, there has been significant technical difficulties in implementing of metal plate with a hollow structure integrally with a heat dissipation substrate during internal research.

On the other hand, according to the power semiconductor module 500 according to the embodiment, since the hot press process is performed in a vacuum environment of high temperature and high pressure, the heat dissipation substrate 400 can be implemented integrally equipped with a second metal plate 422 having a hollow structure HE capable of encapsulating a working fluid.

Accordingly, according to the embodiment, the heat transfer path between the power semiconductor device 100, which is a heat source, and the second metal plate 422 having a hollow structure HE can be significantly shortened, thereby improving heat transfer efficiency. So, there is a technical effect in that heat dissipation performance can be significantly improved as the working fluid can be vaporized efficiently.

In addition, according to the embodiment, since a heat dissipation substrate 400 can be implemented integrally with a second metal plate 422 having a hollow structure HE capable of encapsulating a working fluid, heat can be transferred to the second metal plate 422 having a hollow structure HE without passing through adhesive layer. Accordingly, the efficiency of heat transfer can be improved, and the vaporization of the working fluid can proceed efficiently, resulting in a technical effect of significantly improving heat dissipation performance.

In addition, the heat dissipation substrate 400 according to the embodiment includes a second metal plate 422 having a hollow structure HE and a first metal integrally bonded to the lower side of the second metal plate 422 such that the interface between the first metal plate 421 and the second metal plate 422 is substantially undistinguished. In addition, the material of the second metal plate 422 having the hollow structure HE and the material of the first metal plate 421 formed integrally below the second metal plate 422 are the same. Accordingly, the difference in thermal expansion coefficient between the first metal plate 421 and the second metal plate 422 is resolved, so there is a special technical effect in that the reliability of the power semiconductor module can be significantly improved due to fundamentally preventing separation of the joint interface or warpage of bonded components.

### (6) Inspection, etching and cutting processes of heat dissipation substrates, etc.

Hereinafter, the inspection process, etching process, and cutting process of the heat dissipation substrate will be described. A cleaning process, inspection process, and etching process may be performed on each heat dissipation substrate manufactured through the hot press bonding process. For example, a brush cleaning, water washing, and drying process may be performed on the heat dissipation substrate 400 of the embodiment manufactured through a hot press bonding process, but the process is not limited thereto.

Additionally, in an embodiment, an ultrasonic inspection of the bonding interface may be performed on a hot press manufactured heat dissipation substrate. For example, according to the embodiment, the interface thickness, voids, and cracks of the bonding interface of each heat dissipation substrate may be inspected using ultrasonic inspection equipment.

According to an embodiment, the unique code UC formed in the dummy area can be opened by partially removing the metal plate in the dummy area of each heat dissipation substrate after the hot press bonding process. According to an embodiment, there is a special technical effect of being able to precisely update and manage inspection information on the interface thickness, presence of voids, and cracks on the bonding interface of individual heat dissipation substrates after the hot-pressing process.

Afterwards, an etching process to form a circuit pattern may be performed on the heat dissipation substrate determined to be a good product in the inspection process. For example, a circuit pattern may be formed on the third metal plate 423 through an etching process on the heat dissipation substrate 400 in an embodiment in which a hot press process was performed. For example, the third metal plate 423 may include a plurality of circuit patterns (not shown) formed through a patterning process such as etching, and the circuit patterns may be electrically connected to the power semiconductor device 100.

For example, as shown in FIG. 11A, one side of the circuit pattern of the third metal plate 423 may be electrically connected to the power semiconductor device 100 through a wiring 130a such as a wire. Additionally, the other side of the circuit pattern of the third metal plate 423 may be connected to an external connection terminal. External connection terminals may include input power, motors, or inverter controllers.

The embodiment has a special technical effect in that the etching information (etchant, etching process conditions, etc.) for individual heat dissipation substrates can be precisely updated and managed after the hot press process.

If the etching process to form the circuit pattern is not performed, it can be used as a heat dissipation component. And it may be the same as the heat dissipation substrate process after the etching process.

Next, the laser scribing process, inspection process, and cutting process for the heat dissipation substrate will be described. For example, an etching inspection may be performed on a heat dissipation substrate for which the etching process has been completed. For heat dissipation substrates that have a good etching test, a unique code UC may be marked on the metal plate. For example, when one heat dissipation substrate includes 9 snap regions, unique information UC can be marked on each snap of first metal plate 421 not having circuit pattern. The unique information UC marking on each snap area of the first metal plate 421 may be performed after laser scribing.

Next, the laser scribing process and breaking process can be carried out. In an embodiment, an inspection process may be performed after the laser scribing process and before the breaking process. The inspection process may include ultrasonic testing (SAT), which secondarily inspects voids or cracks at the joint interface using ultrasonic waves. In addition, the inspection process after the laser scribing process may include a process of analyzing surface information such as surface roughness, surface pinhole inspection, protrusion inspection, and foreign matter inspection through an automatic appearance inspection process. The embodiment has a special technical effect in that secondary bonding interface inspection information and automatic appearance inspection information for individual heat dissipation substrates can be precisely updated and managed after the etching process.

Afterwards, an individual heat dissipation substrate 400 can be manufactured as shown in FIG. 10 through a cutting and separation process for the final good product. The bottom of the first metal plate 421 of the heat dissipation substrate 400 of the embodiment shown in FIG. 10 may be delivered with a unique code UC marked on it. Accordingly, according to the embodiment, unique information that can confirm information about the history of all processes from the initial warehousing stage of the product can be perfectly matched to the final product and delivered to the customer, and the customer can also check the product through the unique information. The unique information can be used by accurately understanding quality, production history, etc. Also, after-sales service can be processed quickly and accurately when necessary. Meanwhile, simply marking the product information on the heat dissipation substrate of the final product cannot perfectly match and manage the information, such as the thickness information of the insulating substrate, the thickness information of the metal plate, and the bonding interface information of the product.

### <Power converter including heat dissipation substrate>

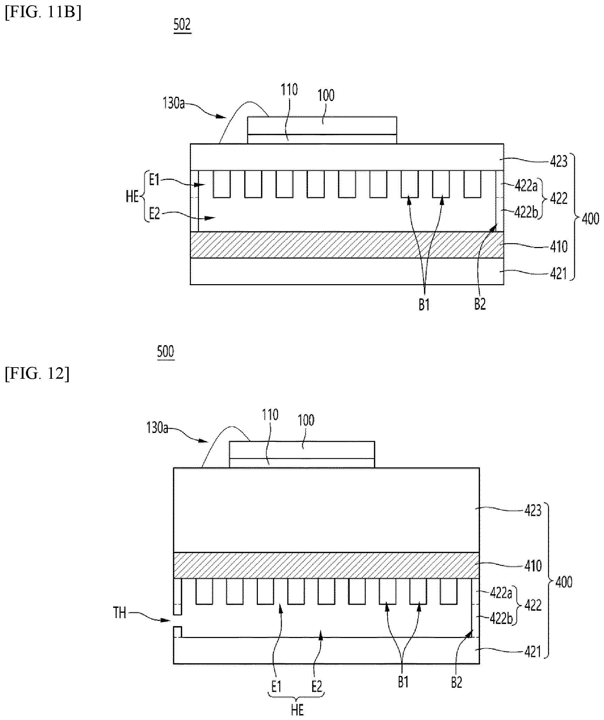

FIG. 11A is a first cross-sectional view of a power semiconductor module 500 including a heat dissipation substrate according to an embodiment, and FIG. 12 is a second cross-sectional view of a power semiconductor module 500 including a heat dissipation substrate for a power semiconductor according to an embodiment.

As described above, an individual heat dissipation substrate 400 can be manufactured as shown in FIG. 10 through a snap-by-snap cutting and separation process for the final good heat dissipation substrate on which the circuit pattern is formed.

Next, referring to FIG. 12, a working fluid inlet TH may be formed on one side of the second metal plate 422 of the heat dissipation substrate 400 of the power semiconductor module 500 according to the embodiment, and a working fluid (not shown) may be injected into a hollow structure HE and the fluid inlet TH may be closed. The working fluid may be acetone, methanol, ethanol, or ultrapure water (DI-water), but is not limited thereto.

According to the embodiment, as the heat generated from the power semiconductor device 100 can be efficiently transferred to the second metal plate 422 of the heat dissipation substrate, the working fluid can be vaporized and the latent heat of evaporation can be absorbed. After then, the working fluid moves in the direction of the lower first metal plate 421 and condenses, the working fluid can be condensed into a liquid while releasing latent heat of evaporation. The condensed working fluid may be absorbed into the porous structure of the second metal plate 422 and moved toward the insulating substrate 410. In an embodiment, the power semiconductor device 100, which is a heat source, may be placed below the heat dissipation substrate 400 and the condensed working fluid may be moved using gravity.

Next, FIG. 11B is a cross-sectional view of the power semiconductor module 502 including a heat dissipation substrate according to the second embodiment. The second embodiment can adopt the technical features of the previously described embodiment, and the description below will focus on the main features of the second embodiment.

Referring to FIG. 11B, the power semiconductor module 502 according to the second embodiment may include a heat dissipation substrate 400, a power semiconductor device 100 disposed on the heat dissipation substrate 400, the power semiconductor device 100, and a wiring 130a electrically connected to the power semiconductor device 100.

The power semiconductor module 502 according to the second embodiment may include a first metal plate 421, an insulating substrate 410, a second metal plate 422, and a third metal plate 423, but it is not limited to this.

In particular, in the second embodiment, a hollow structure HE capable of filling a working fluid may be disposed between the power semiconductor device 100 and the insulating substrate 410.

For example, the second metal plate 422 of the second embodiment may be disposed between the insulating substrate 410 and the third metal plate 423, and the second metal plate 422 may have a hollow structure HE. In the second embodiment, the power semiconductor device 100 may be disposed on the third metal plate 423, but is not limited thereto.

The second metal plate 422 of the second embodiment may include a single or multiple metal plates. For example, the second metal plate 422 may include a second-first metal plate 422a having a first through trench E1 and a first body B 1. Additionally, the second metal plate 422 may further include a second-second metal plate 422b having a second body B2 and a second through trench E2. The first trench E1 and the second trench E2 of the second metal plate 422 can provide a three-dimensional hollow structure, and the hollow structure can be filled with operating acetone, methanol, ethanol, ultra-water purification, etc.

Additionally, the first body B1 and the second body B2 of the second metal plate 422 may include a porous structure that can contain or absorb the working fluid. For example, the first body B1 and the second body B2 of the second metal plate 422 may be formed through a sintering process and may include a porous structure. Alternatively, the first body B1 and the second body B2 of the second metal plate 422 may have grooves in the form of fine grooves on their side walls. Alternatively, the first body B1 and the second body B2 of the second metal plate 422 may include a mesh-shaped porous structure.

Meanwhile, in the conventional heat dissipation substrate technology field, the heat dissipation problem was solved by separately combining or placing various heat dissipation components such as heat sinks, heat dissipation plates, heat pipes, and vapor chambers on the heat dissipation substrate, or the metal constituting the heat dissipation substrate. There was no consideration or research on forming heat dissipation components integrally with the metal plate itself.

Furthermore, the heat dissipation substrate includes an insulating substrate, a lower metal plate and an upper metal plate disposed above and below the insulating substrate, respectively. And the 'upper metal plate' functions as a wiring board on which a circuit pattern is formed by etching in addition to the heat dissipation function.

Accordingly, in the conventional heat dissipation substrate technology field, there has been no attempt to form a metal plate with a hollow structure integrally with the heat dissipation substrate, and in particular, this was difficult to consider because the hollow structure could be damaged by etching the 'upper metal plate' on which the circuit pattern is formed.

In addition, even considering the fact that the 'upper metal plate' has a hollow structure, it is difficult to form a precise circuit pattern on the 'upper metal plate', where the insulating substrate is exposed by etching and the circuit pattern is formed. So, implementing the upper metal plate equipped with the hollow structure has been a very difficult technical challenge as a result of a considerable period of internal research.

On the other hand, according to the second embodiment, the second metal plate 422 having a grid-shaped hollow structure can be placed on the insulating substrate 410 and can be hot pressed in a high temperature and high pressure vacuum environment. As the process progresses, a heat dissipation substrate in which the second metal plate 422, which has a hollow structure capable of encapsulating a working fluid, can be integrally provided with the upper metal plate.

For example, according to the second embodiment, the hollow structure is not placed in the first area to be removed by etching, but the hollow structure is placed in the second area not to be removed by etching. After preparing and stacking the metal plate 422, a hot press process may be performed in a high-temperature and high-pressure vacuum environment.

For example, FIG. 11B is a cross-sectional view of the second area of the second metal plate 422 where the hollow structure HE is disposed.

Accordingly, according to the second embodiment, although a hollow structure is provided in the second region of the upper second metal plate 422 where the circuit pattern is formed, the subsequent etching process is performed in the first region where the hollow structure is not disposed. As this progresses and the insulating substrate is exposed, a circuit pattern can be formed. Through this, according to the second embodiment, there is a special technical effect that can solve the problem of technical contradiction in which the hollow structure is damaged by etching when the 'upper metal plate' is provided with a hollow structure.

According to the second embodiment, as the heat generated from the power semiconductor device 100 can be efficiently transferred to the second metal plate 422, the working fluid is vaporized through the hollow structure to absorb latent heat of evaporation. After then, the working fluid moves in the direction of the insulating substrate 410, the first metal plate 421 and condenses into a liquid while releasing latent heat of evaporation. Additionally, the condensed working fluid may be absorbed into the porous structure of the second metal plate 422 and moved toward the third metal plate 423.

According to the power semiconductor module 502 including the heat dissipation substrate 400 for power semiconductors according to the second embodiment, since the hot press process is performed in a vacuum environment of high temperature and high pressure, the heat dissipation substrate 400 can be implemented integrally equipped with a second metal plate 422 having a hollow structure capable of encapsulating a working fluid.

Accordingly, according to the second embodiment, the heat transfer path between the power semiconductor device 100, which causes heat generation, and the second metal plate 422 having a hollow structure can be significantly shortened, thereby improving heat transfer efficiency. There is a technical effect that heat dissipation performance is significantly improved by efficiently vaporizing the fluid.

In particular, in the second embodiment, the second metal plate 422 having a hollow structure in which the working fluid can be sealed is disposed between the power semiconductor device 100 and the insulating substrate 410, the heat transfer path between the power semiconductor device 100 and the second metal plate 422 having a hollow structure can be significantly shortened, thereby dramatically improving heat dissipation performance.

In addition, according to the second embodiment, a heat dissipation substrate may be implemented integrally equipped with a second metal plate 422 having a hollow structure capable of encapsulating a working fluid in the heat dissipation substrate 400 itself without intervening a separate adhesive layer. Accordingly, heat can be transferred to the second metal plate 422 having a hollow structure through the third metal plate 423 without going through an adhesive layer that may cause thermal resistance, and this improves heat transfer efficiency. There is a technical effect of significantly improving heat dissipation performance.

In addition, the heat dissipation substrate 400 according to the second embodiment includes a second metal plate 422 having a hollow structure (HE) and a third metal 423 integrally bonded to the lower side of the second metal plate 422 such that the interface between the third metal plate 423 and the second metal plate 422 is substantially undistinguished. In addition, the material of the second metal plate 422 having the hollow structure (HE) and the material of the third metal plate 423 formed integrally below the second metal plate 422 are the same. Accordingly, the difference in thermal expansion coefficient between the third metal plate 423 and the second metal plate 422 is resolved, so there is a special technical effect in that the reliability of the power semiconductor module can be significantly improved due to fundamentally preventing separation of the joint interface or warpage of bonded components.

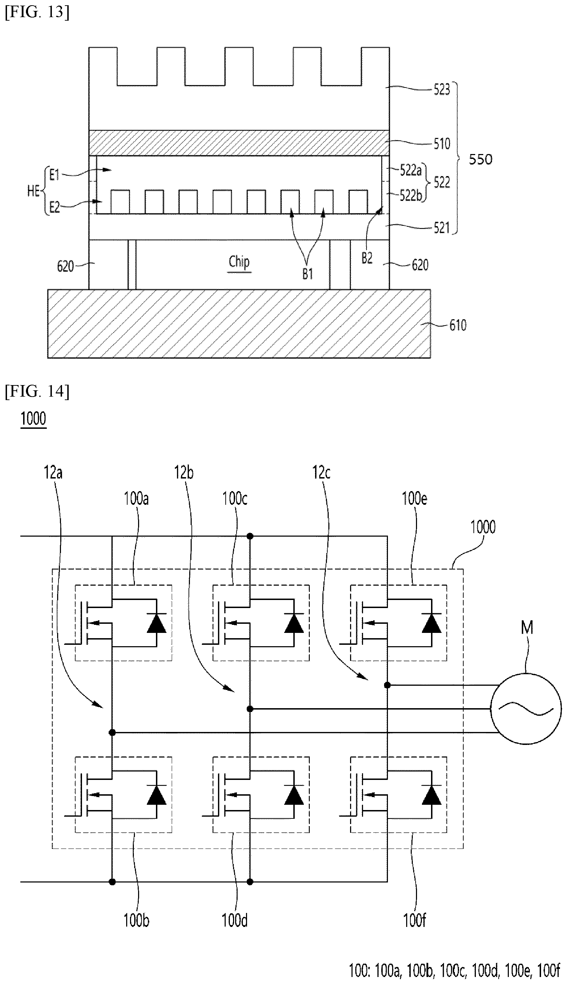

Next, FIG. 13 is a diagram showing a heat dissipation component 550 according to an embodiment disposed on a semiconductor device chip of the circuit board 610.

For example, posts 620 may be placed spaced apart on a circuit board 610, and a semiconductor device chip may be placed inside the post 620 of the circuit board 610. The semiconductor device chip may be a Si semiconductor device or a SiC semiconductor device, but is not limited thereto. The post 620 may have excellent heat transfer performance and may be made of an electrically insulating material, but is not limited thereto.

Referring to FIG. 13, the heat dissipation component 550 according to the embodiment may be bonded to the semiconductor device chip by a predetermined adhesive member (not shown), but is not limited thereto. For example, the heat dissipation component 550 is connected to the semiconductor device chip through soldering, sintering bonding, transient liquid phase (TLP) bonding, ultrasonic bonding, etc.

The heat dissipation component 550 of the embodiment may include a single or multiple metal plates and an insulating substrate 510. For example, the heat dissipation component 550 may include a first metal plate 521, a second metal plate 522, an insulating substrate 510, and a third metal plate 523, but is not limited thereto.

The insulating substrate 510 may electrically insulate the second metal plate 522 and the third metal plate 523. The insulating substrate 510 may include a polycrystalline insulating substrate made of a ceramic material with high thermal conductivity. For example, the insulating substrate 510 may be one of AlN, Si₃N₄ or Al₂O₃, etc. Hereinafter, the insulating substrate 510 will be described as an example of a polycrystalline substrate made of ceramic, but is not limited thereto, and may also include a single crystal substrate such as a sapphire substrate.

The first metal plate 521, the second metal plate 522, and the third metal plate 523 may include Cu-based metal, but are not limited thereto. For example, the first, second, and third metal plates 521, 522, and 523 may include one or more of Al, Ni, Ag, Mg, and Zn.

One side of the second metal plate 522 is in contact with the insulating substrate 510 and heat can be dissipated to the other side.

In the embodiment, the second metal plate 522 may include a single or multiple metal plates. For example, the second metal plate 522 may include a second-first metal plate 522a having a first through trench E1 and a second body B2. Additionally, the second metal plate 522 may further include a second-second metal plate 522b having a first body B1 and a second through trench E2.

The second metal plate 522 is shown as including a second-first metal plate 522a and a second-second metal plate 522b, but is not limited thereto and may include a single metal plate. there is.

In the second metal plate 522, the first through trench E1 and the second through trench E2 may be three-dimensionally connected to form a hollow structure HE which may be filled with a working fluid (not shown) such as acetone, methanol, ethanol, or ultrasonic water.

In addition, the first body B1 and the second body B2 of the second metal plate 522 may include a porous structure that can contain or absorb the working fluid. For example, the first body B1 and the second body B2 of the second metal plate 522 may be formed through a sintering process and may include a porous structure. Alternatively, the first body B1 and the second body B2 of the second metal plate 522 may have grooves in the form of fine grooves on their side walls. Alternatively, the first body B1 and the second body B2 of the second metal plate 522 may include a mesh-shaped porous structure.

According to the embodiment, as the heat generated from the semiconductor device chip is efficiently transferred to the second metal plate 522 of the heat dissipation substrate, the working fluid is vaporized and the latent heat of evaporation is absorbed. After then, the working fluid can move in the direction of the upper third metal plate 523 and condense into a liquid while releasing latent heat of evaporation, and the condensed working fluid can be absorbed into the porous structure of the second metal plate 522 and move in the direction of the first metal plate 521.

Next, the third metal plate 523 may be in the form of a heat sink. For example, the third metal plate 523 may include a plurality of heat dissipation fins formed through a patterning process such as etching, but is not limited thereto.

Also, in the embodiment, the third metal plate 523 may include a second hollow structure (not shown) corresponding to the hollow structure HE. For example, the third metal plate 523 may include a third-first metal plate (not shown) and a third-second metal plate (not shown) sequentially arranged from the insulating substrate 510.

In addition, the third metal plate 523 includes a third through trench (not shown) and a fourth through trench provided in the third-first metal plate (not shown) and the third-second metal plate (not shown). The third through trench (not shown) and the fourth through trench (not shown) can be three-dimensionally connected to form a second hollow structure, and the second hollow structure may be filled with a working fluid (not shown) such as acetone, methanol, ethanol, or ultrasonic water.

The heat dissipation part 550 according to the embodiment can be subjected to a hot press process in a vacuum environment of high temperature and high pressure. So, the second metal plate 522 having a hollow structure HE that can enclose the working fluid in the heat dissipation part 550 itself can be implemented integrally.

In addition, according to the embodiment, the heat transfer path between the semiconductor device causing heat generation and the second metal plate 522 having a hollow structure HE can be shortened, and heat transfer efficiency can be improved, due to making vaporization of the working fluid more efficient such that there is has the technical effect of significantly improving heat dissipation performance.

In addition, according to the embodiment, a heat dissipation component 550 can be implemented integrally equipped with a second metal plate 522 itself having a hollow structure capable of encapsulating a working fluid without intervening a separate adhesive layer. Accordingly, heat can be transferred to the second metal plate 522 having a hollow structure without going through an adhesive layer that may cause thermal resistance, and this improves heat transfer efficiency such that there is a technical effect of significantly improving heat dissipation performance.

In addition, the heat dissipation component 550 according to the embodiment includes a second metal plate 522 having a hollow structure HE and a first metal plate 521 integrally bonded to the lower side of the second metal plate 522 such that the interface between the first metal plate 521 and the second metal plate 422 can be substantially undistinguished. In addition, the material of the second metal plate 522 having the hollow structure (HE) and the material of the first metal plate 521 formed integrally below the second metal plate 522 are the same. Accordingly, the difference in thermal expansion coefficient between the first metal plate 521 and the second metal plate 522 is resolved, so there is a special technical effect in that the reliability of the power semiconductor module can be significantly improved due to fundamentally preventing separation of the joint interface or warpage of bonded components.

Next, FIG. 14 is an example circuit diagram of a power converter 1000 to which a power semiconductor module according to an embodiment is applied.

In the embodiment, the power semiconductor device describes an automobile inverter for driving a motor, but the power semiconductor device in the embodiment can be applied to inverters or converters in the various technical fields described above. Here, vehicles include hybrid vehicles (HEV), plug-in hybrid vehicles (PHEV), electric vehicles (EV), and fuel cell vehicles (PCEV).

The power converter 1000 according to the embodiment can receive DC power from a battery or fuel cell and convert it into AC power, and supply AC power to a predetermined load. For example, the power converter 1000 according to the embodiment may include an inverter and convert DC power from a battery. For example, the power converter 1000 can receive input, convert it into three-phase AC power, and supply it to the motor (M), and the motor (M) can provide power to electric vehicles, fuel cell vehicles, etc.

The power converter 1000 according to the embodiment may include a power semiconductor device 100. The power semiconductor device 100 may be a MOSFET (Metal Oxide Semiconductor Field Effect Transistor), but is not limited thereto, and may include an IGBT (Insulated Gate Bipolar Transistor).

For example, the power converter 1000 may include a plurality of power semiconductor devices (100a, 100b, 100c, 100d, 100e, 100f) and a plurality of diodes (not shown). Each of the plurality of diodes may be embedded in each of the power semiconductor devices 100a, 100b, 100c, 100d, 100e, and 100f in the form of an internal diode, but is not limited thereto, and may be disposed separately.

The embodiment may convert DC power to AC power through on-off control of a plurality of power semiconductor devices 100a to 100f. For example, the power converter 1000 according to the embodiment turns on the first power semiconductor device 100a and turns off the second power semiconductor device 100b in the first time period of one cycle to operate the motor M. Positive polarity power may be supplied, and negative polarity power may be supplied to the motor M by turning off the first power semiconductor device 100a and turning on the second power semiconductor device 100b in the second time period of one cycle.

In the embodiment, a group of power semiconductor devices arranged in series on the high-voltage line and low-voltage line on the input side may be called an arm. For example, the first and second power semiconductor devices 100a and 100b form the first arm 12a, and the third and fourth power semiconductor devices 100c and 100d form the second arm 12b, and the fifth and sixth power semiconductor devices 100e and 100f may form the third arm 12c.

A plurality of power semiconductor devices 100a to 100f shown in FIG. 14 may be packaged into one power semiconductor module, or the power semiconductor devices constituting each arm may be packaged into one power semiconductor module. In the arm, the upper power semiconductor device and the lower power semiconductor device may be controlled so that they are not turned on at the same time. For example, in the first arm, the first power semiconductor device 100a and the second power semiconductor device 100b may not be turned on at the same time but may be alternately turned on and off.

The power semiconductor device 100 of the embodiment may be a silicon carbide (SiC) power semiconductor device, can operate in a high temperature and high voltage environment, and may have high switching speed and low switching loss.

Although the present invention has been described above with reference to embodiments, those skilled in the art will understand the present invention without departing from the scope of the present invention as set forth in the following patent claims. It will be easy to understand that it can be modified and changed in various ways.

## Claims

1. A heat dissipation substrate for a power semiconductor module, comprising:
an insulating substrate (410);
a lower metal plate (421, 422) disposed below the insulating substrate (410); and
an upper metal plate (423) disposed on the insulating substrate (410),
wherein the lower metal plate (421, 422) comprises a hollow structure HE.

2. The heat dissipation substrate according to claim 1, wherein the lower metal plate (421, 422) comprises a second metal plate (422) bonded to a bottom of the insulating substrate (410); and a first metal plate (421) bonded to the bottom of the second metal plate (422).

3. The heat dissipation substrate according to claim 2, wherein the second metal plate (422) comprises a second-first metal plate (422a) having a plurality of first through trenches (E1) arranged in a first direction and bonded to the insulating substrate (410).

4. The heat dissipation substrate according to claim 3, wherein the second metal plate (422) comprises a second-second metal plate (422b) having a plurality of second through trenches (E2) arranged in a second direction perpendicular to the first direction and bonded to a bottom of the second-first metal plate (422a).

5. The heat dissipation substrate according to claim 4, wherein the second-first metal plate (422a) comprises a first body (B1) between a plurality of spaced apart first through trenches (E1), and the second-second metal plate (422b) comprises a second body (B2) between a plurality of spaced apart second through trenches (E2).

6. The heat dissipation substrate according to any one of claims 2 to 5, wherein the upper metal plate (423) comprises a third metal plate (423) bonded to the insulating substrate (410), and wherein a thickness of the third metal plate (423) is thicker than that of the first metal plate (421) or the second metal plate (422).

7. The heat dissipation substrate according to claim 6, wherein the third metal plate (423) comprises a circuit pattern on its surface.

8. The heat dissipation substrate according to claim 6 or 7, wherein the first metal plate (421), the second metal plate (422), and the third metal plate (423) comprise the same metal material.

9. The heat dissipation substrate according to any one of claims 2 to 8, wherein the second metal plate (422) is directly bonded to the bottom of the insulating substrate without an adhesive layer, and the first metal plate (421) is directly bonded to the bottom of the second metal plate without an adhesive layer.

10. A power semiconductor module, comprising:
a heat dissipation substrate (400) for a power semiconductor module according to any one of claims 1 to 9; and
a power semiconductor device (100) disposed on the upper metal plate (423).

11. A power converter (1000) comprising the power semiconductor module according to claim 10.

12. A method of manufacturing a heat dissipation substrate for a power semiconductor module, comprising:
preparing an insulating substrate (410);
preparing a first metal plate (421), a second metal plate (422), and a third metal plate (423);
sequentially stacking the first metal plate (421) and the second metal plate (422);
stacking the insulating substrate (410) on the second metal plate (422);
preparing a stacked substrate set by stacking the third metal plate (423) on the insulating substrate (410); and
performing a hot press process on the stacked set of substrates,
wherein the second metal plate (422) comprises a second-first metal plate (422a) having a plurality of first through trenches (E1) arranged in a first direction.

13. The method of manufacturing a heat dissipation substrate according to claim 12, wherein the second metal plate (422) comprises a second-second metal plate (422b) having a plurality of second through trenches (E2) arranged in a second direction perpendicular to the first direction and bonded to the insulating substrate (410).

14. The method of manufacturing a heat dissipation substrate according to claim 13, wherein the second-first metal plate (422a) comprises a first body (B1) between a plurality of spaced apart first through trenches (E1), and the second-second metal plate (422b) comprises a second body (B2) between a plurality of spaced apart second through trenches (E2).

15. The method of manufacturing a heat dissipation substrate according to claim 12, wherein the second metal plate (422) is directly bonded to the bottom of the insulating substrate without an adhesive layer, and the first metal plate (421) is directly bonded to the bottom of the second metal plate without an adhesive layer.
